# FASCICULE DE BREVET EUROPEEN

(11) **EP 3 361 498 B1**
(45) Date de publication et mention de la délivrance du brevet: **04.08.2021**
(21) Numéro de dépôt: 17186741.9
(22) Date de dépôt: 17.08.2017
(51) Int. Cl.: H01L 49/02, H01L 23/64, H01L 23/58, H01L 29/94, H01L 25/16

(54) **CONDENSATEUR DE DÉCOUPLAGE**
ENTKOPPLUNGSKONDENSATOR
DECOUPLING CAPACITOR

(30) Priorité: 13.02.2017 FR 1751154
(43) Date de publication de la demande: 15.08.2018
(73) Titulaire: STMicroelectronics (Crolles 2) SAS, 38920 Crolles (FR); STMicroelectronics (Rousset) SAS, 13790 Rousset (FR)
(72) Inventeur: LISART, Mathieu, 13100 Aix en Provence (FR); FROMENT, Benoît, 38000 Grenoble (FR)
(74) Mandataire: Cabinet Beaumont

(56) Documents cités:
- FR-A1- 2 976 721
- US-A1- 2007 134 852

## Description

### Domaine

La présente demande concerne les circuits électroniques intégrés, plus particulièrement un circuit intégré muni d'une protection face arrière du circuit.

### Exposé de l'art antérieur

Des circuits intégrés subissent parfois des attaques visant à déterminer la structure du circuit, à en modifier le fonctionnement ou à en extraire des informations confidentielles. Une attaque peut être effectuée depuis la face arrière d'un circuit muni en face avant de composants tels que des condensateurs, des diodes ou des transistors revêtus de pistes conductrices. Au cours de l'attaque, une portion de la face arrière est d'abord gravée, approximativement jusqu'au niveau de caissons dans lesquels sont formés les composants. Une ouverture plus petite, par exemple de 2 x 2 µm, est faite dans cette portion de la face arrière approximativement jusqu'au niveau de zones actives et de tranchées d'isolement dites STI, de l'anglais "Shallow Trench Isolation". A partir de cette ouverture, des cavités sont réalisées par exemple par un faisceau d'ions et s'étendent vers la face avant jusqu'au niveau des composants ou des pistes conductrices. Des contacts électriques avec les composants ou les pistes sont ensuite créés dans ces cavités, et les pirates utilisent ces contacts pour analyser le circuit en fonctionnement.

Un circuit intégré susceptible de subir une telle attaque peut comprendre plusieurs centaines de condensateurs de découplage. Ces condensateurs de découplage servent à limiter l'influence des perturbations de tension sur le circuit. Les condensateurs de découplage peuvent correspondre à plus de 20 % de la surface du circuit intégré et sont, comme les autres éléments du circuit intégré, agencés en cellules. Ces cellules sont formées entre une bande conductrice à un potentiel VDD et une bande conductrice à la masse. Ces bandes sont généralement communes à un grand nombre de cellules.

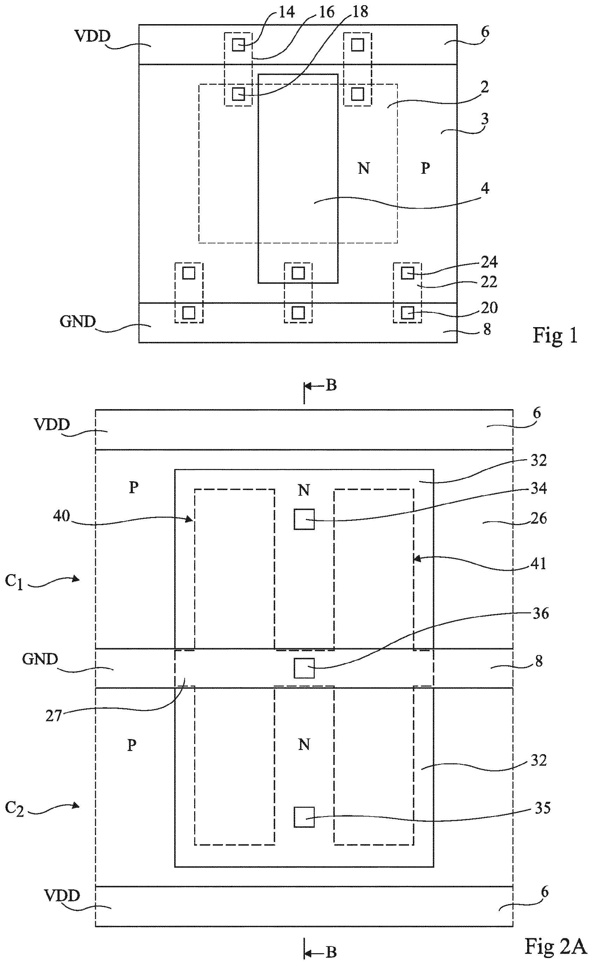

La figure 1 représente schématiquement en vue de dessus un exemple de cellule de condensateur formant un condensateur de découplage. La cellule comprend un caisson 2 dopé de type N, figuré en pointillés, dans un substrat 3 dopé de type P. Une bande conductrice 4, par exemple en silicium polycristallin, est formée sur le caisson 2, avec interposition d'une couche de diélectrique non représentée. Cette bande conductrice 4 correspond à une bande de grille d'un transistor MOS et une implantation P est réalisée dans le caisson 2 en utilisant cette bande 4 comme masque.

La cellule est disposée entre des bandes conductrices d'alimentation, par exemple une bande 6 à une tension positive VDD et une bande 8 à la masse (GND). Des contacts 14 sont formés sur la bande 6 et sont reliés, par des pistes conductrices 16 figurées en pointillés, à des contacts 18 avec les zones implantées dans le caisson 2. De même, des contacts 20 sont formés sur la bande 8 et sont reliés, par des pistes conductrices 22 figurées en pointillés, à des contacts 24 formés sur la couche 10 ou sur le substrat 3, les reliant tous deux à la masse.

Un condensateur est donc formé entre la partie du caisson 2 située sous la bande conductrice 4 et cette bande conductrice 4.

Il est facile de creuser des trous traversant ces condensateurs de découplage sans perturber le fonctionnement du circuit. En effet, les cellules contenant les condensateurs de découplage comprennent peu d'éléments clés et suffisamment d'espace pour le passage de contacts. Les emplacements où se trouvent les condensateurs de découplage risquent donc d'être tout particulièrement ciblés par des pirates.

Il est souhaitable de disposer de condensateurs de découplage protégés contre les attaques décrites précédemment.

### Résumé

Ainsi, l'invention propose un condensateur de découplage selon la revendication 1.

Selon un mode de réalisation, les cellules sont disposées entre deux bandes conductrices d'alimentation, de part et d'autre d'une bande d'alimentation centrale.

Selon un mode de réalisation, le condensateur est formé par la première tranchée isolée et par des deuxièmes tranchées isolées s'étendant dans le caisson dans une direction orthogonale à celle de la première tranchée isolée.

Selon un mode de réalisation, des condensateurs à tranchée isolée sont formés dans le substrat dans lequel est formé le caisson.

Un mode de réalisation prévoit un circuit intégré contenant un condensateur de découplage tel que décrit ci-dessus et un circuit de détection de l'impédance entre les contacts avec le caisson au niveau de chaque cellule.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente schématiquement un condensateur ;
les figures 2A et 2B sont une vue de dessus et une vue en coupe illustrant deux cellules de condensateur protégés contre les attaques face arrière selon l'invention ;
la figure 3 est une vue de dessus d'une cellule de circuit intégré ;
la figure 4A est une vue de dessus plus détaillée d'un mode de réalisation de deux cellules de condensateur protégés contre des attaques face arrière ; et
les figures 4B à 4D sont diverses vues en coupe des cellules de la figure 4A.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des qualificatifs de position, tels que les termes "avant", "arrière", "sous", "horizontal", "vertical", etc., il est fait référence à la position des éléments concernés dans les figures. Sauf précision contraire, l'expression "approximativement" doit être interprétée comme signifiant à 10 % près, de préférence à 5 % près.

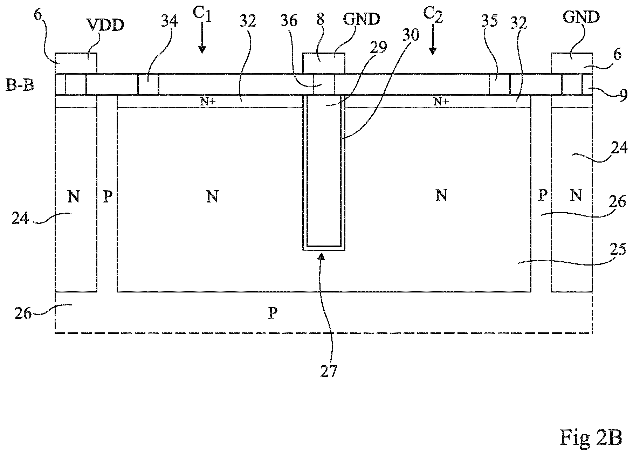

Les figures 2A et 2B sont une vue de dessus et une vue en coupe selon la ligne B-B de la figure 2A, représentant deux cellules de condensateur selon l'invention, ces condensateurs étant protégés contre des attaques face arrière. Les condensateurs sont des condensateurs réalisés à partir de tranchées isolées.

Comme cela a été décrit précédemment, chaque cellule est disposée entre une bande conductrice à un potentiel VDD et une bande conductrice à la masse (GND). Les deux cellules représentées C1, C2 sont formées entre deux bandes conductrices 6 au potentiel VDD de part et d'autre d'une bande conductrice 8 à la masse, commune aux deux cellules. Les bandes conductrices 6 et 8 sont par exemple des bandes métalliques séparées des couches sous-jacentes par un isolant 9, représenté en figure 2B, et connectées à des régions choisies par des vias conducteurs et éventuellement des pistes conductrices non représentées.

Les deux cellules C1, C2 partagent un même caisson 25 dopé de type N, formé dans un substrat 26 dopé de type P. Une tranchée 27 est formée entre les deux cellules, dans le caisson 25. La tranchée 27 s'étend sous la bande conductrice 8 sur au moins toute la largeur du caisson 25 mais à une profondeur plus faible que la profondeur du caisson 25, comme cela est visible en figure 2B. La partie du caisson 25 de la cellule C1 et la partie du caisson 25 de la cellule C2 sont connectées par une portion du caisson 25 située sous la tranchée 27. La tranchée 27 a un coeur conducteur, par exemple en silicium polycristallin 29, séparé du caisson 25 par une gaine de matériau diélectrique 30, par exemple de l'oxyde de silicium.

Le caisson 25 dopé de type N est recouvert d'une couche 32 fortement dopée de type N. Un contact 34, 35 est formé sur chacune des deux parties de la couche 32 séparées par la tranchée 27. Un contact 36 relie le coeur 29 de la tranchée 27 à la bande conductrice 8, au potentiel de référence GND.

On prévoit ici que, par intermittence, par exemple de manière périodique, les contacts 34 et 35 sont utilisés pour vérifier la continuité du caisson 25 entre les deux cellules, par exemple en mesurant l'impédance entre les deux contacts, qui est comparé à une valeur de référence. Pour cela, les contacts 34 et 35 sont connectés à un circuit non représenté capable, par intermittence, de prendre une mesure, par exemple une mesure du courant parcourant le caisson 25 entre les contacts 34 et 35.

Lors d'une attaque face arrière, telle que décrite précédemment, ciblant de telles cellules, le pirate creusera depuis la face arrière dans le caisson 25. Il se rapprochera du fond de la tranchée 27, par exemple jusqu'à l'atteindre. Cela causera une variation de l'impédance entre les noeuds correspondant aux contacts 34 et 35, qui pourra être mesurée lors d'une mesure suivante. Les mesures de l'impédance entre les contacts 34 et 35 sont suffisamment rapprochées pour permettre une détection rapide d'une attaque face arrière.

Dans les cellules C1 et C2, protégées contre des attaques comme cela a été indiqué ci-dessus, on pourra former des condensateurs de toutes façons classiques. Etant donné que la cellule comprend déjà une tranchée isolée 27, il est souhaitable pour minimiser le nombre d'étapes de fabrication de former ces condensateurs dans des tranchées isolées 40 et 41 du même type que la tranchée 27 de séparation entre les cellules. Ainsi, comme on le voit dans le vue de dessus de la figure 2A, ces tranchées 40 et 41 croisent la tranchée 27 et leurs coeurs conducteurs internes sont communs. Le coeur de la tranchée 27 constitue donc également un élément de condensateur.

En fonctionnement normal, le substrat P 26 sera polarisé à un potentiel GND, le caisson N 25 à un potentiel VDD et le conducteur du coeur 29 des tranchées 27, 40 et 41 à un potentiel GND. Comme cela est représenté, les tranchées 40 et 41 s'étendent sur la longueur des deux cellules et sont de préférence identiques à la tranchée 27.

On soulignera à nouveau que, alors que, en fonctionnement normal, le caisson 25 commun aux deux cellules C1 et C2 est à un potentiel unique, VDD, pendant les phases de détection d'attaque éventuelle, les deux parties de caissons sont par exemple mises à des potentiels différents pour détecter l'impédance présente entre les contacts 34 et 35.

On a décrit précédemment de façon générale et simplifiée une paire de cellules adjacentes contenant des condensateurs agencées de façon à détecter une attaque. On va montrer ci-après que, non seulement comme on l'a exposé précédemment, cet agencement est efficace, mais qu'en outre une structure pratique permettant l'utilisation de cet agencement est particulièrement simple à réaliser.

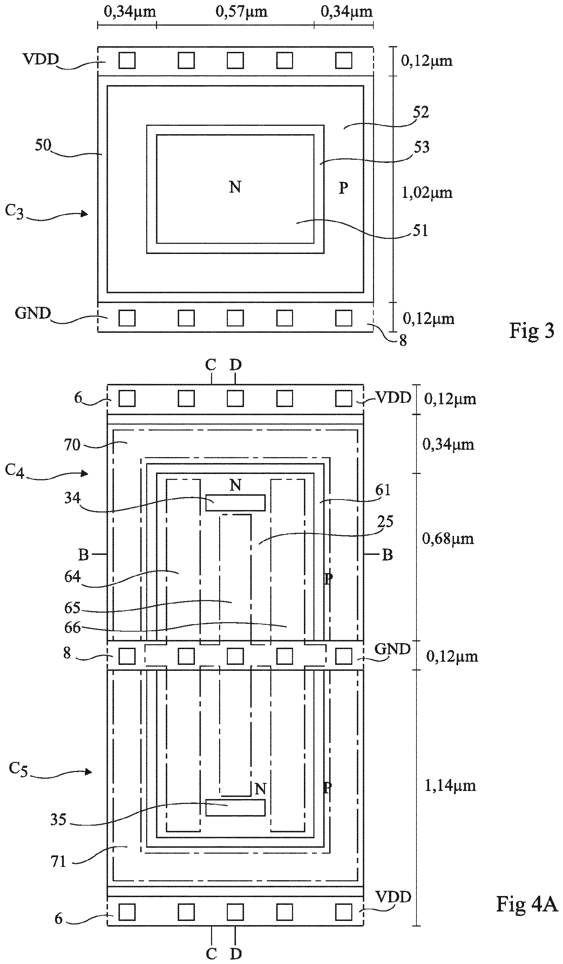

La figure 3 représente un exemple coté d'une cellule d'un circuit intégré réalisée dans une technologie particulière. La cellule, C3, est formée entre deux bandes conductrices 6 et 8 ayant des largeurs de 0,12 µm, respectivement à VDD et GND. La cellule est entourée d'une tranchée d'isolement 50 couramment appelée dans la technique STI (Shallow Trench Isolation - isolement par tranchée peu profonde). La cellule contient un caisson N 51 formé dans un substrat P 52. Le caisson N 51 est entouré d'un mur isolant STI 53. Dans l'exemple considéré, la distance entre les deux bandes conductrices est de 1,02 µm. La dimension latérale du caisson N 51, dans la direction parallèle aux bandes conductrices 6 et 8, est de 0,57 µm et la distance, dans cette même direction, entre le caisson 51 et le coté de la cellule C3 est de 0,34 µm.

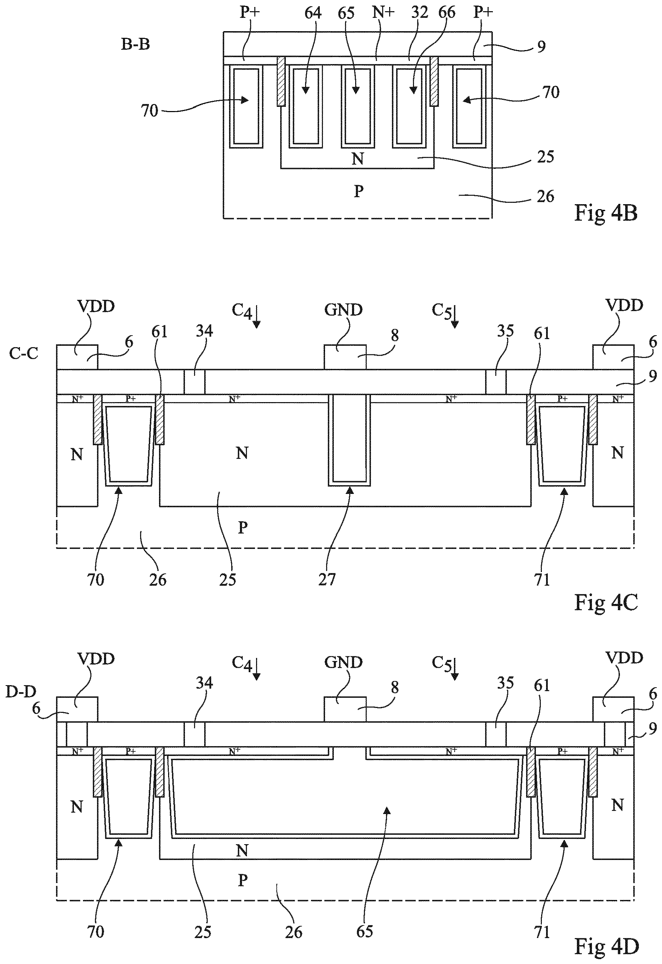

Les figures 4A à 4D représentent un exemple de mode de réalisation de deux cellules de condensateurs protégées contre des attaques face arrière et ayant une capacité totale élevée au vu de la surface de cellule disponible et des technologies de fabrication existantes. La figure 4A est une vue de dessus, cotée, et les figures 4B à 4D sont des vues en coupe selon les lignes B-B, C-C et D-D de la figure 4A.

Comme l'illustre les figures 4A à 4D, on utilise, selon un mode de réalisation, deux cellules adjacentes C4 et C5 de part et d'autre d'une bande conductrice 8 à la tension de référence GND et entre des bandes conductrices 6 à la tension de référence VDD. Les dimensions horizontales de la structure sont celles illustrées en figure 3. Un caisson N 25, entouré d'une tranchée isolante STI 61, s'étend sur l'ensemble des deux cellules de la façon représentée. La limite supérieure du caisson 25 se trouve à 0,34 µm de la bande conductrice 6 la plus proche, et sa limite inférieure se trouve à la même distance de l'autre bande conductrice 6. Le caisson 25 est formé dans un substrat de type P 26. Comme cela a été décrit en relation avec les figures 2A et 2B, une tranchée isolée 27 s'étend dans le caisson N 25 sous la bande conductrice à GND 8. Dans cette structure, on peut placer, verticalement à l'intérieur du caisson N 25, trois tranchées isolées 64, 65, et 66 ayant des largeurs de l'ordre de 0,16 µm, ce qui est parfaitement compatible avec les règles de dessin de la technologie considérée. Une des tranchées 64, 65 et 66 a une longueur inférieure à celle des autres tranchées, de manière à permettre la formation des contacts de mesure 34 et 35 sur une couche fortement dopée de type N 32, formée sur le caisson 25, tel que cela est décrit en relation avec les figures 2A et 2B. De même, à la périphérie du caisson N 25, on peut placer dans le substrat P 26 des tranchées connectées à une bande conductrice 6, isolées du substrat dopé P 26 et de la couche fortement dopée P, discontinues entre leur partie supérieure et leur partie inférieure, 70 du côté supérieur et 71 du côté inférieur. A nouveau, la réalisation de tranchées d'une largeur de l'ordre de 0,16 µm est parfaitement compatible avec les règles de dessin de la technologie considérée.

Les figures 4B, 4C et 4D qui sont respectivement des vues en coupe selon les lignes B-B, C-C et D-D de la figure 4A permettent de mieux comprendre la réalisation de la structure. Ces figures ne seront pas décrites en détails car elles se comprennent d'elles-mêmes. Les divers éléments de ces figures sont désignés par de même références qu'en figure 4A et, quand il y a lieu, qu'en figures 2A et 2B. On notera en particulier la présence des contacts de mesure 34 et 35. Les parties hachurées correspondent à des murs isolants STI.

L'objectif de la description de la figure 4A et de la présence des figures 4B, 4C, 4D est de montrer que la structure décrite ici est particulièrement simple à réaliser dans un cas pratique. Bien entendu, diverses réalisations distinctes, selon la technologie et les règles de dessin impliquées pourront être utilisées. Dans tous les cas, la réalisation pratique sera simple.

Dans le cas particulier représenté, en figures 4A à 4D, on obtient, pour une paire de cellules, non seulement un condensateur ayant une capacité de 10 pF, ce qui constitue une valeur particulièrement élevée pour la faible surface de silicium utilisée, mais aussi des cellules de condensateurs de découplage protégés d'une attaque face arrière.

## Revendications

1. Condensateur de découplage comprenant :
deux cellules (C1, C2) de condensateurs partageant un même caisson (25) dopé de type N formé dans un substrat (26) dopé de type P ;
une première tranchée isolée (27) traversant le caisson entre les deux cellules sans atteindre le fond du caisson, la première tranchée isolée ayant un coeur conducteur (29) qui constitue un élément du condensateur ; et
un contact (34, 35) avec le caisson formé au niveau de chaque cellule.

2. Condensateur selon la revendication 1, dans lequel les cellules (C1, C2) sont disposées entre deux bandes conductrices d'alimentation (6), de part et d'autre d'une bande d'alimentation centrale (8).

3. Condensateur selon la revendication 1 ou 2, dans lequel le condensateur est formé par la première tranchée isolée (27) et par des deuxièmes tranchées isolées (40, 41) s'étendant dans le caisson (25) dans une direction orthogonale à celle de la première tranchée isolée (27).

4. Condensateur selon l'une quelconque des revendications 1 à 3, comportant en outre des condensateurs à tranchée isolée (70, 71) formés dans le substrat (26) dans lequel est formé le caisson (25).

5. Circuit intégré contenant un condensateur de découplage selon l'une quelconque des revendications 1 à 4 et un circuit de détection de l'impédance entre les contacts (34, 35) avec le caisson au niveau de chaque cellule.

## Patentansprüche

1. Entkopplungskondensator, der Folgendes aufweist
zwei Kondensatorzellen (C1, C2), die sich dieselbe n-dotierte Wanne (25) teilen, die in einem p-dotierten Substrat (26) ausgebildet ist;
ein erster Trenngraben (27), der durch die Wanne zwischen den beiden Zellen verläuft, ohne den Boden der Wanne zu erreichen, wobei der erste Trenngraben einen leitenden Kern (29) aufweist, der ein Element des Kondensators bildet; und
einen Kontakt (34, 35) mit der Wanne, der in jeder Zelle ausgebildet ist.

2. Kondensator nach Anspruch 1, wobei die Zellen (C1, C2) zwischen zwei leitenden Versorgungsstreifen (6) auf beiden Seiten eines zentralen Versorgungsstreifens (8) angeordnet sind.

3. Kondensator nach Anspruch 1 oder 2, wobei der Kondensator durch den erste Trenngraben (27) und durch zweite Trenngräben (40, 41) gebildet wird, die sich in der Wanne (25) in einer Richtung orthogonal zum ersten Trenngraben (27) erstrecken.

4. Kondensator nach einem der Ansprüche 1 bis 3, der ferner Trenngrabenkondensatoren (70, 71) aufweist, die in dem Substrat (26) ausgebildet sind, in dem die Wanne (25) ausgebildet ist.

5. Integrierte Schaltung, die einen Entkopplungskondensator nach einem der Ansprüche 1 bis 4 und eine Schaltung zur Erfassung der Impedanz zwischen den Kontakten (34, 35) mit der Wanne in jeder Zelle aufweist.

## Claims

1. Decoupling capacitor comprising:
two capacitor cells (C1, C2) sharing the same n-doped well (25) formed in a p-doped substrate (26);
a first trench isolation (27) passing through the well between the two cells without reaching the bottom of the well, the first trench isolation having a conductive core (29) constituting an element of the capacitor; and
a contact (34, 35) with the well formed in each cell.

2. Capacitor according to Claim 1, wherein the cells (C1, C2) are placed between two conductive supply strips (6), on either side of a central supply strip (8).

3. Capacitor according to Claim 1 or 2, wherein the capacitor is formed by the first trench isolation (27) and by second trench isolations (40, 41) extending in the well (25) in a direction orthogonal to that of the first trench isolation (27).

4. Capacitor according to any one of Claims 1 to 3, including capacitors comprising a trench isolation (70, 71) formed in the substrate (26) in which the well (25) is formed.

5. Integrated circuit containing a decoupling capacitor according to any one of Claims 1 to 4 and a circuit for detecting the impedance between the contacts (34, 35) with the well in each cell.
